# EUROPEAN PATENT APPLICATION

(11) **EP 4 343 871 A1**
(43) Date of publication of application: **27.03.2024**
(21) Application number: 22804258.6
(22) Date of filing: 08.02.2022
(51) Int. Cl.: H01L 51/44, H01L 51/46, H01L 31/048

(54) **SOLAR CELL AND SOLAR CELL MANUFACTURING METHOD**

(30) Priority: 21.05.2021 JP 2021086529
(71) Applicant: Panasonic Holdings Corporation, Osaka 571-8501 (JP)
(72) Inventor: SEKIMOTO, Takeyuki, Kadoma-shi, Osaka 571-0057 (JP); MATSUI, Taisuke, Kadoma-shi, Osaka 571-0057 (JP); NAKAMURA, Toru, Kadoma-shi, Osaka 571-0057 (JP)
(74) Representative: Grünecker Patent- und Rechtsanwälte PartG mbB
(86) International application number: PCT/JP2022/004777
(87) International publication number: WO 2022/244336

(57) **Abstract**

A solar cell 1000 according to the present disclosure comprises a support 2, a photoelectric conversion element 1, and a sealing member 3. The photoelectric conversion element 1 is in a sealed space defined by the support 2 and the sealing member 3. The photoelectric conversion element 1 comprises, in this order, a first electrode, a photoelectric conversion layer, and a second electrode, and an oxygen concentration in the sealed space is greater than or equal to 10 ppm and less than or equal to 3000 ppm in terms of volume fraction.

## Description

### Technical Field

The present disclosure relates to a solar cell and a method of producing a solar cell.

### Background Art

In recent years, a perovskite solar cell, which uses a perovskite crystal structure represented by a composition formula ABX₃ (in which A is a monovalent cation, B is a divalent cation, and X is a halogen anion) or a similar crystal structure (hereinafter referred to as a "perovskite compound") as a photoelectric conversion material, has been under research and development. Various efforts are being made to improve the photoelectric conversion efficiency and the durability of the perovskite solar cell.

NPL 1 reports that oxygen reacts with cation in a perovskite compound under illumination of light, and the reaction generates metal oxide or hydroxide on a surface or a grain boundary of the perovskite compound.

### Citation List

### Patent Literature

PTL 1: Japanese Unexamined Patent Application Publication No. 2017-103450

### Non Patent Literature

NPL 1: Q. Sun and eight others, "Advanced Energy Materials", July 2017, Vol. 7, p. 1700977

### Summary of Invention

### Technical Problem

An object of the present disclosure is to improve durability of a solar cell.

### Solution to Problem

A solar cell according to the present disclosure comprises:
a support;
a photoelectric conversion element, and
a sealing member, wherein
the photoelectric conversion element is in a sealed space defined by the support and the sealing member,
the photoelectric conversion element comprises, in this order, a first electrode, a photoelectric conversion layer, and a second electrode, and
the sealed space has an oxygen concentration of greater than or equal to 10 ppm and less than or equal to 3000 ppm in terms of volume fraction.

### Advantageous Effects of Invention

According to the present disclosure, a solar cell can have improved durability.

### Brief Description of Drawings

[Fig. 1] Fig. 1 illustrates a schematic configuration of a solar cell 1000 according to an embodiment of the present disclosure.
[Fig. 2] Fig. 2 is a cross-sectional view illustrating a schematic configuration of a first configuration example of a photoelectric conversion element 1 of the solar cell 1000 according to the embodiment of the present disclosure.
[Fig. 3] Fig. 3 is a cross-sectional view illustrating a schematic configuration of a second configuration example of the photoelectric conversion element 1 of the solar cell 1000 according to the embodiment of the present disclosure.
[Fig. 4] Fig. 4 is a cross-sectional view illustrating a schematic configuration of a third configuration example of the photoelectric conversion element 1 of the solar cell 1000 according to the embodiment of the present disclosure.
[Fig. 5] Fig. 5 is a graph showing oxygen concentration dependence of normalized photoelectric conversion efficiency of solar cells according to Examples 1 to 4 and Comparative Examples 1 to 3.
[Fig. 6] Fig. 6 is a graph showing oxygen amount dependence of normalized photoelectric conversion efficiency of solar cells according to Examples 1 to 4 and Comparative Examples 1 to 3.

### Description of Embodiments

### <Underlying Knowledge Forming Basis of the Present Disclosure>

As reported in NPL 1, a perovskite compound containing lead reacts with oxygen under illumination of light and generates lead oxide (PbO) or lead hydroxide (Pb(OH)₂) on a surface or a grain boundary of the perovskite compound. If the reaction products, which have high-insulating properties, are produced in large amounts, movement of photogenerated carriers is inhibited. This deteriorates the characteristics of the perovskite solar cell. To avoid this problem, perovskite solar cells are generally used in a nitrogen atmosphere that has very little oxygen (e.g., an oxygen concentration of less than or equal to 0.1 ppm in terms of volume fraction). In this specification, the oxygen concentrations described below are all concentrations in terms of volume fraction.

NPL 1 discloses that normalized photoelectric conversion efficiency of perovskite solar cells after light exposure tests decreases monotonically, based on when an oxygen concentration around the solar cell is 0%, as the oxygen concentration increases from 1% to 20%.

PTL 1 discloses that a perovskite solar cell having a sealed structure has oxygen and moisture in the sealed space. It is disclosed that the heat resistance of the solar cell is improved by controlling the oxygen concentration in the space to greater than or equal to 5% and the moisture concentration (volume fraction) to less than or equal to 300 ppm. It is disclosed here that the moisture concentration needs to be controlled in the above range because the oxidant of the hole transport material is reduced by moisture.

However, NPL 1 reports that the light resistance decreases at the oxygen concentration of 5%. Thus, when the oxygen concentration is greater than or equal to 5%, the durability of the solar cell may be insufficient.

PTL 1 does not disclose data for oxygen concentrations of less than 2%.

Considering these prior technologies, the inventors conducted detailed research to find the oxygen concentration that significantly affects the durability. The research found that the optimal oxygen concentration for the durability of solar cells exists within a certain range where the oxygen concentration is less than 2% in terms of volume fraction. Specifically, in a solar cell having a sealing structure, the photoelectric conversion efficiency after a light exposure test is improved when the oxygen concentration in the sealed space is in the range of greater than or equal to 10 ppm and less than or equal to 3000 ppm. Furthermore, when the oxygen concentration in the sealed space is greater than or equal to 100 ppm and less than or equal to 3000 ppm, the photoelectric conversion efficiency after a heat resistance test is also improved.

### <Description of Embodiments>

A solar cell according to an embodiment of the present disclosure comprises a support, a photoelectric conversion element, and a sealing member, wherein the photoelectric conversion element is in a sealed space defined by the support and the sealing member. The photoelectric conversion element comprises, in this order, a first electrode, a photoelectric conversion layer, and a second electrode. The oxygen concentration in the sealed space is greater than or equal to 10 ppm and less than or equal to 3000 ppm.

The above-described configuration can reduce the photodegradation induced by defects in the photoelectric conversion material. Thus, the solar cell can have improved durability.

In the solar cell according to this embodiment, the oxygen concentration in the sealed space may be greater than or equal to 100 ppm and less than or equal to 3000 ppm.

The above-described configuration can sufficiently passivate defects in the photoelectric conversion material, and thus heat-induced structural changes in the photoelectric conversion material are less likely to occur, resulting in improvement in the thermal stability of the solar cell. Thus, the above-described configuration enables the solar cell to have both the photostability and the thermal stability. In other words, the above-described configuration can provide a solar cell having further improved durability.

The oxygen concentration in the sealed space can be measured by an atmospheric pressure ionization mass spectrometer, gas chromatography, and an electrochemical oxygen sensor. The gas whose oxygen concentration to be measured is the gas that is taken out from the sealed space with a syringe at room temperature (25°C) or the gas that is allowed to escape from the sealed space by breaking the solar cell module in a closed space. The components of the gas are measured, and the percentage of oxygen is calculated to determine the oxygen concentration. Here, an example of a method of measuring the oxygen concentration is described. In the method, the gas in the sealed space of a solar cell is allowed to escape to a closed space, and the oxygen concentration in the outflowed gas is measured by using an atmospheric pressure ionization mass spectrometer. For example, the solar cell module is placed in a chamber filled with an inert gas, such as argon or krypton. The module is broken in the chamber to let the gas out the sealed space of the solar cell. Next, quantitative analysis is performed on the gas in the chamber by using an atmospheric pressure ionization mass spectrometer. All the components of the gas in the chamber are quantified, and the percentage of oxygen in the sum of the quantities is calculated to determine the oxygen concentration. Examples of gases in the sealed space, other than oxygen, include an inert gas, such as nitrogen and noble gases, carbon dioxide, and water vapor. If the sealed space contains the inert gas that is the same in type as the inert gas filling the chamber used for the gas analysis, accurate gas analysis may be difficult. To solve the problem, when the type of gas contained in the sealed space is unknown, two identical solar cell modules are provided, and the analysis of the gas is performed for each of the two solar cell modules by the above-described procedure using different types of inert gases as the inert gas filling the chamber. The composition of the gas contained in the sealed space can be determined when the results of the two analyses are compared.

The partial pressure of oxygen in the sealed space may be greater than or equal to 1 × 10⁻⁵ atm and less than or equal to 3 × 10⁻³ atm.

The above-described configuration can more readily reduce the photodegradation induced by defects in the photoelectric conversion material. Thus, the solar cell can have improved durability.

When the solar cells according to the present disclosure are produced under atmospheric pressure, the pressure in the sealed space is about atmospheric pressure. In this case, the partial pressure of oxygen in the sealed space is greater than or equal to 1 × 10⁻⁵ atm and less than or equal to 3 × 10⁻³ atm.

To calculate the partial pressure of oxygen in the sealed space, the mass or molar concentration of the gas containing oxygen in the sealed space is determined by using the above-described method of measuring the oxygen concentration, and the volume of the sealed space is measured. Then, the partial pressure is calculated by using an equation of state of a gas. The volume of the sealed space can be determined by a method other than size measurement. For example, after a vacuum is drawn in the sealed space, an inert gas of known pressure and volume is injected into the sealed space, and the volume may be determined from the pressure change, or a liquid of known density is injected into the sealed space, and the volume may be determined from the weight change. The above-described measurements are usually performed at room temperature, but the temperature is not limited to this. In other words, the measurements may be performed at an actual operating temperature such that the effects of adsorption and desorption of gases in the sealed space can be taken into consideration.

Modifications of the solar cell according to the embodiment of the present disclosure will be described. The same explanation can be appropriately omitted.

As described above, the solar cell according to the present disclosure comprises a support, a photoelectric conversion element, and a sealing member, wherein the photoelectric conversion element is in a sealed space defined by the support and the sealing member. The photoelectric conversion element comprises, in this order, a first electrode, a photoelectric conversion layer, and a second electrode. The amount of oxygen in the sealed space per surface area of the surface facing the sealed space of the photoelectric conversion element may be greater than or equal to 2.3 × 10⁻⁷ mol/m² and less than or equal to 7.0 × 10⁻⁵ mol/m². In other words, the value obtained by dividing the amount of oxygen in the sealed space by the area of the surface of the photoelectric conversion element facing the sealed space may be greater than or equal to 2.3 × 10⁻⁷ mol/m² and less than or equal to 7.0 × 10⁻⁵ mol/m². This can reduce degradation due to long-term operation of the solar cell.

In the photoelectric conversion element, the main surface of the first electrode may face the support, or the main surface of the second electrode may face the support.

The solar cell according to the present disclosure can be produced, for example, by the following method.

First, a photoelectric conversion element is produced by the method described below.

The produced photoelectric conversion element is sealed with a sealing member in a glove box having the controlled oxygen concentration.

The oxygen concentration in the glove box is greater than or equal to 10 ppm and less than or equal to 3000 ppm. Alternatively, the oxygen concentration in the glove box is adjusted such that the amount of oxygen in the sealed space per surface area of the surface facing the sealed space of the photoelectric conversion element is greater than or equal to 2.3 × 10⁻⁷ mol/m² and less than or equal to 7.0 × 10⁻⁵ mol/m².

The pressure and an oxygen concentration in the glove box may be controlled such that the partial pressure of oxygen in the sealed space becomes greater than or equal to 1 × 10⁻⁵ atm and less than or equal to 3 × 10⁻³ atm.

With the above-described configuration, a solar cell having a predetermined oxygen concentration, a predetermined oxygen content, or a predetermined oxygen partial pressure can be produced.

As described above, a photoelectric conversion element comprising, in this order, a first electrode, a photoelectric conversion layer, and a second electrode may be sealed in an atmosphere having an oxygen concentration of greater than or equal to 10 ppm and less than or equal to 3000 ppm in terms of volume fraction to produce a solar cell.

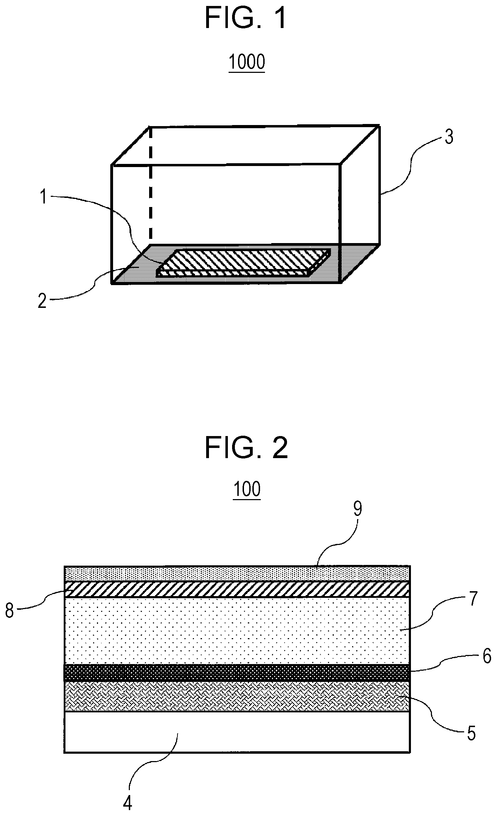

Fig. 1 illustrates a schematic configuration of the solar cell 1000 according to the embodiment of the present disclosure.

The solar cell 1000 according to this embodiment includes a photoelectric conversion element 1, a support 2, and a sealing member 3. The photoelectric conversion element 1 is in the sealed space defined by the support 2 and the sealing member 3.

The photoelectric conversion element 1 may be in contact with the support 2.

The support 2 and the sealing member 3 may be formed of the same material. The material may, for example, have a gas barrier function. The material may be glass.

Hereinafter, the photoelectric conversion element 1 is described in more detail with reference to first to third configuration examples. The photoelectric conversion element 1 is not limited to the photoelectric conversion elements in the following first to third configuration examples.

Fig. 2 is a cross-sectional view illustrating a schematic configuration of the first configuration example of the photoelectric conversion element 1 in the solar cell 1000 according to an embodiment of the present disclosure.

The first configuration example of the photoelectric conversion element 100 comprises, in this order, a substrate 4, a first electrode 5, an electron transport layer 6, a photoelectric conversion layer 7, a hole transport layer 8, and a second electrode 9. As the first configuration example of the photoelectric conversion element 100, the photoelectric conversion element 1 in the solar cell 1000 according to this embodiment may further comprise an electron transport layer between the first electrode and the photoelectric conversion layer and may further comprise a hole transport layer between the photoelectric conversion layer and the second electrode.

When the photoelectric conversion element 100 is irradiated with light, the photoelectric conversion layer 7 absorbs the light and generates excited electrons and holes. The excited electrons move through the electron transport layer 6 to the first electrode 5. The holes generated at the photoelectric conversion layer 7 move through the hole transport layer 8 to the second electrode 9. This allows current to be drawn from the photoelectric conversion element 100 through the first electrode 5 as the negative electrode and the second electrode 9 as the positive electrode.

The photoelectric conversion element 100 may or may not include the substrate 4.

The photoelectric conversion element 100 may or may not include the electron transport layer 6. When the photoelectric conversion element 100 includes the electron transport layer 6, electrons can be efficiently moved to the first electrode 5. Thus, current can be efficiently drawn from the photoelectric conversion element 100.

The photoelectric conversion element 100 may or may not include the hole transport layer 8. When the photoelectric conversion element 100 includes the hole transport layer 8, holes can be efficiently moved to the second electrode 9. Thus, current can be efficiently drawn from the photoelectric conversion element 100.

The photoelectric conversion element 100 can be produced, for example, by the following method.

First, the first electrode 5 is formed on the surface of the substrate 4 by, for example, chemical vapor deposition or sputtering. Then, the electron transport layer 6 is formed by, for example, chemical vapor deposition, sputtering, or solution coating. Then, the photoelectric conversion layer 7 is formed on the electron transport layer 6. The photoelectric conversion layer 7 may be formed, for example, by solution coating, printing, or vapor deposition. Alternatively, for example, a perovskite compound cut to a predetermined thickness may be used as the photoelectric conversion layer 7 and placed on the electron transport layer 6. Then, the hole transport layer 8 is formed on the photoelectric conversion layer 7 by, for example, chemical vapor deposition, sputtering, or solution coating. Then, the second electrode 9 is formed on the hole transport layer 8 by, for example, chemical vapor deposition, sputtering, or solution coating. The photoelectric conversion element 100 is produced as above.

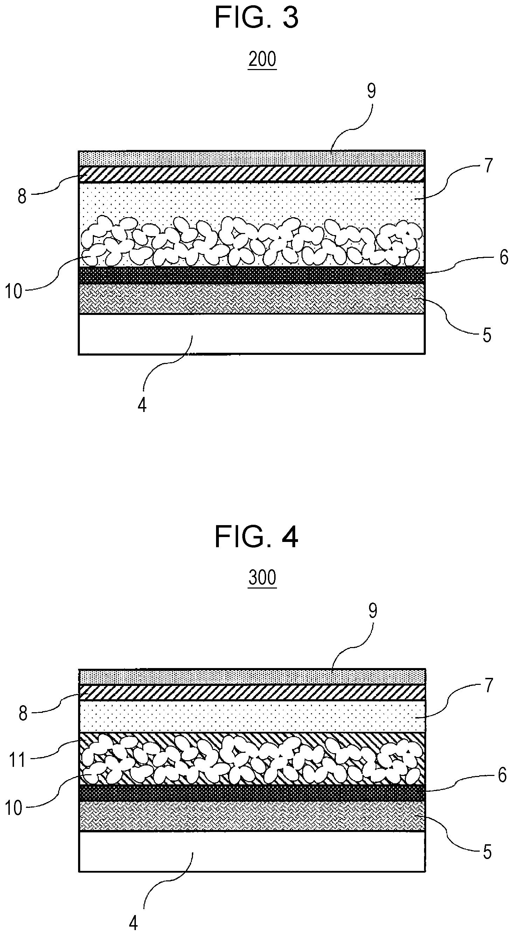

Fig. 3 is a cross-sectional view illustrating a schematic configuration of a second configuration example of the photoelectric conversion element 1 in the solar cell 1000 according to the embodiment of the present disclosure.

A photoelectric conversion element 200 comprises, in this order, the substrate 4, the first electrode 5, the electron transport layer 6, a porous layer 10, the photoelectric conversion layer 7, the hole transport layer 8, and the second electrode 9. As the photoelectric conversion element 200 of the second configuration example, the photoelectric conversion element 1 in the solar cell 1000 according to this embodiment may further include the porous layer. The porous layer is located, for example, between the electron transport layer and the photoelectric conversion layer.

The porous layer 10 contains a porous material. The porous material contains voids.

The photoelectric conversion element 200 may or may not include the substrate 4.

The photoelectric conversion element 200 may or may not include the electron transport layer 6. If the photoelectric conversion element 200 does not include the electron transport layer 6, the porous layer 10 is located between the first electrode 5 and the photoelectric conversion layer 7. When the photoelectric conversion element 200 includes the electron transport layer 6, electrons can be efficiently moved to the first electrode 5. Thus, current can be efficiently drawn from the photoelectric conversion element 200.

The photoelectric conversion element 200 may or may not include the hole transport layer 8. When the photoelectric conversion element 200 includes the hole transport layer 8, holes can be efficiently moved to the second electrode 9. Thus, current can be efficiently drawn from the photoelectric conversion element 200.

Fig. 4 is a cross-sectional view illustrating a schematic configuration of a third configuration example of the photoelectric conversion element 1 in the solar cell 1000 according to the embodiment of the present disclosure.

A photoelectric conversion element 300 of the third configuration example comprises, in this order, the substrate 4, the first electrode 5, the electron transport layer 6, the porous layer 10, an intermediate layer 11, the photoelectric conversion layer 7, the hole transport layer 8, and the second electrode 9. As the photoelectric conversion element 300 of the third configuration example, the photoelectric conversion element 1 in the solar cell 1000 according to this embodiment may further include the intermediate layer. The intermediate layer is located, for example, between the porous layer and the photoelectric conversion layer.

The photoelectric conversion element 300 may or may not include the substrate 4.

The photoelectric conversion element 300 may or may not include the electron transport layer 6. When the photoelectric conversion element 300 includes the electron transport layer 6, electrons can be efficiently moved to the first electrode 5. Thus, current can be efficiently drawn from the photoelectric conversion element 300.

The photoelectric conversion element 300 may or may not include the hole transport layer 8. When the photoelectric conversion element 300 includes the hole transport layer 8, holes can be efficiently moved to the second electrode 9. Thus, current can be efficiently drawn from the photoelectric conversion element 300.

The photoelectric conversion element 300 may or may not include the porous layer 10. When the photoelectric conversion element 300 does not include the porous layer 10, the intermediate layer 11 is located between the electron transport layer 6 and the photoelectric conversion layer 7.

Hereinafter, the components of the photoelectric conversion element will be described specifically.

### (Substrate 4)

The substrate 4 is an optional component. The substrate 4 holds the layers of the photoelectric conversion element. The substrate 4 can be formed of a transparent material. For example, the substrate 4 may be a glass substrate or a plastic substrate. The plastic substrate may be, for example, a plastic film.

If the second electrode 9 has light-transmitting properties, the substrate 4 may be formed of a non-light-transmitting material. Examples of the material include metals, ceramics, and resin materials having low light-transmitting properties.

If the first electrode 5 has sufficient strength, the first electrode 5 can hold the layers, eliminating the need for the substrate 4.

### (First Electrode 5)

The first electrode 5 is conductive.

The first electrode 5 has light-transmitting properties. For example, the first electrode 5 transmits light in the visible range to the near-infrared range.

The first electrode 5 is composed of, for example, a transparent and conductive material. Examples of the material include metal oxides and metal nitrides. Examples of them include:
(i) titanium dioxide doped with at least one selected from the group consisting of lithium, magnesium, niobium, and fluorine;
(ii) gallium oxide doped with at least one selected from the group consisting of tin and silicon;
(iii) gallium nitride doped with at least one selected from the group consisting of silicon and oxygen;
(iv) tin oxide doped with at least one selected from the group consisting of antimony and fluorine;
(v) zinc oxide doped with at least one selected from the group consisting of boron, aluminum, gallium, and indium; (vi) indium-tin composite oxide; and
(vii) a compound of the above materials.

The first electrode 5 may have a light-transmitting pattern. Examples of the light-transmitting pattern include a line pattern, a wave pattern, a lattice pattern, a perforated metal-like pattern having many fine through holes regularly or irregularly arranged. When the first electrode 5 has any of these patterns, light can pass through portions having no electrode material. Thus, the light-transmitting pattern enables non-transparent materials to be used. Examples of the non-transparent electronic material include platinum, gold, silver, copper, aluminum, rhodium, indium, titanium, iron, nickel, tin, zinc, and alloys containing at least one of these. A conductive carbon material may be used as a non-transparent electrode material.

When the photoelectric conversion element does not include the electron transport layer 6, the first electrode 5 has blocking properties against holes from the photoelectric conversion layer 7. In such a case, the first electrode 5 is not in ohmic contact with the photoelectric conversion layer 7. Furthermore, the blocking properties against holes from the photoelectric conversion layer 7 are properties that only allow passage of electrons generated in the photoelectric conversion layer 7 and does not allow passage of holes. The Fermi energy of a material having such properties is higher than the energy of the photoelectric conversion layer 7 at the upper end of the valence band. The Fermi energy of a material having such properties may be higher than the Fermi energy of the photoelectric conversion layer 7. A specific example of the material is aluminum.

When the photoelectric conversion element includes the electron transport layer 6, the first electrode 5 may have no blocking properties against holes from the photoelectric conversion layer 7. In this case, the first electrode 5 may be formed of a material that can form an ohmic contact with the photoelectric conversion layer 7. In this case, the first electrode 5 may or may not be in ohmic contact with the photoelectric conversion layer 7.

The light transmittance of the first electrode 5 may be, for example, greater than or equal to 50%, or greater than or equal to 80%. The wavelength of light to be transmitted through the first electrode 5 depends on the absorption wavelength of the photoelectric conversion layer 7.

The thickness of the first electrode 5 may be, for example, greater than or equal to 1 nm and less than or equal to 1000 nm.

### (Electron Transport Layer 6)

The electron transport layer 6 contains a semiconductor. The electron transport layer 6 may be formed of a semiconductor having a band gap of greater than or equal to 3.0 eV. This allows transmission of visible and infrared light to the photoelectric conversion layer 7. An example of the semiconductor is an inorganic n-type semiconductor.

Examples of the inorganic n-type semiconductor include metal oxide, metal nitride, and perovskite-type oxide. Examples of the metal oxide include oxides of Cd, Zn, In, Pb, Mo, W, Sb, Bi, Cu, Hg, Ti, Ag, Mn, Fe, V, Sn, Zr, Sr, Ga, Si, and Cr. The metal oxide is, for example, TiO₂ or SnO₂. The metal nitride is, for example, GaN. The perovskite-type oxide is, for example, SrTiO₃ or CaTiO₃.

The electron transport layer 6 may contain a material having a band gap of greater than 6.0 eV. Examples of such a material include:
(i) halides of alkali metals such as lithium fluoride and halides of alkaline earth metals such as calcium fluoride;
(ii) alkali metal oxides, such as magnesium oxide; and
(iii) silicon dioxide.

In this case, the electron transport layer 6 may have a thickness of less than or equal to 10 nm, for example, to have electron transport properties.

The electron transport layer 6 may include multiple layers formed of different materials.

### (Photoelectric Conversion Layer 7)

The photoelectric conversion layer 7 contains a photoelectric conversion material.

The photoelectric conversion material may be, for example, a perovskite compound. In other words, the photoelectric conversion layer 7 may comprise a perovskite compound. The perovskite compound has a high optical absorption coefficient in the wavelength range of the solar spectrum and high carrier mobility. Thus, the photoelectric conversion element containing a perovskite compound has high photoelectric conversion efficiency.

The perovskite compound is represented, for example, by the composition ABX₃. A is a monovalent cation. Examples of the monovalent cation include alkali metal cations and organic cations. Examples of the alkali metal cations include a potassium cation (K⁺), a cesium cation (Cs⁺), and a rubidium cation (Rb⁺). Examples of organic cations include a methylammonium cation (MA⁺ or CH₃NH₃⁺), a formamidinium cation (FA⁺ or HC(NH₂)₂⁺), an ethylammonium cation (CH₃CH₂NH₃⁺), and a guanidinium cation (CH₆N₃⁺). B is a divalent cation. Examples of the divalent cation include a lead cation (Pb²⁺) and a tin cation (Sn²⁺). X is a monovalent anion. Examples of the monovalent anion include a halogen anion. Each of the A, B, and X sites may be occupied by two or more types of ions.

The photoelectric conversion material may be, for example, a lead-containing perovskite compound.

The thickness of the photoelectric conversion layer 7 is, for example, greater than or equal to 50 nm and less than or equal to 10 µm.

The photoelectric conversion layer 7 is formed, for example, by solution coating, printing, or vapor deposition. The photoelectric conversion layer 7 may be formed by placing a perovskite compound that has been cut out.

The photoelectric conversion layer 7 may contain a perovskite compound represented by the composition formula ABX₃ as a main component. Here, "the photoelectric conversion layer 7 contains a perovskite compound represented by the composition formula ABX₃ as a main component" means that the photoelectric conversion layer 7 contains greater than or equal to 90% by mass of a perovskite compound represented by the composition formula ABX₃. The photoelectric conversion layer 7 may contain greater than or equal to 95 % by mass of a perovskite compound represented by the composition formula ABX₃. The photoelectric conversion layer 7 may be composed of a perovskite compound represented by the composition formula ABX₃. The photoelectric conversion layer 7 only needs to contain a perovskite compound represented by the composition formula ABX₃ and may have defects or impurities.

The photoelectric conversion layer 7 may further contain a different compound from the perovskite compound represented by the composition formula ABX₃. Examples of the different other compounds include a compound having a Ruddlesden-Popper type layered perovskite structure.

### (Hole Transport Layer 8)

The hole transport layer 8 contains a hole transport material. The hole transport material transport holes. The hole transport material is, for example, an organic or inorganic semiconductor.

The hole transport layer 8 may comprise an organic semiconductor. The organic semiconductor forms a food interface with the photoelectric conversion layer 7 and can reduce the formation of interface defects during bonding. This enables the photoelectric conversion element to have high photoelectric conversion efficiency and durability.

Examples of the organic semiconductor include triphenylamine, triallylamine, phenylbenzidine, phenylenevinylene, tetrathiafulvalene, vinylnaphthalene, vinylcarbazole, thiophene, aniline, pyrrole, carbazole, triptycene, fluorene, azulene, pyrene, pentacene, perylene, acridine, and phthalocyanine.

Typical examples of the organic semiconductor used as the hole transport material include 2,2',7,7'-tetrakis-(N,N-di-p-methoxyphenylamine)9,9'-spirobifluorene, poly[bis(4-phenyl)(2,4,6-trimethylphenyl)amine] (hereinafter, may be referred to as "PTAA"), poly(3-hexylthiophene-2,5-diyl), poly(3,4-ethylenedioxythiophene), and copper phthalocyanine. These organic semiconductors have high hole transport properties. Thus, the photoelectric conversion efficiency of the photoelectric conversion element can be improved.

The organic semiconductor may comprise at least one selected from the group consisting of 2,2',7,7'-tetrakis-(N,N-di-p-methoxyphenylamine)9,9'-spirobifluorene and PTAA.

The inorganic semiconductor used as the hole transport material is a p-type semiconductor. Examples of the inorganic semiconductor include carbon materials such as Cu₂O, CuGaO₂, CuSCN, CuI, NiOₓ, MoOₓ, V₂O₅, and a graphene oxide. Here, x > 0 is satisfied.

The hole transport layer 8 may include multiple layers formed of different materials. For example, the layers may be laminated such that the ionization potential of the hole transport layer 8 gradually decreases relative to the ionization potential of the photoelectric conversion layer 7. This improves the hole transport properties.

The thickness of the hole transport layer 8 may be greater than or equal to 1 nm and less than or equal to 1000 nm, or greater than or equal to 10 nm and less than or equal to 50 nm. This allows exhibition of sufficient hole transport properties. Thus, the solar cell can keep the low resistance, and thus high photoelectric conversion efficiency can be achieved.

The hole transport layer 8 is formed, for example, by coating, printing, or vapor deposition. This is the same as the photoelectric conversion layer 7. Examples of the coating include a doctor blade method, a bar coating method, a spray method, a dip coating method, and a spin coating method. An example of the printing is a screen-printing method. The hole transport layer 8 may be formed of a mixture of multiple materials and may be pressurized or heat-treated as necessary. If the hole transport layer 8 is formed of an organic low-molecular material or an inorganic semiconductor, the hole transport layer 8 can also be produced by vacuum deposition.

The hole transport layer 8 may comprise an additive in addition to the hole transport material to improve the conductivity. Examples of the additive include a supporting electrolyte, a solvent, and a dopant. The supporting electrolyte and the solvent stabilize the holes in the hole transport layer 8. The dopant increases the number of holes in the hole transport layer 8.

Examples of the supporting electrolyte include an ammonium salt, an alkaline earth metal salt, and a transition metal salt. Examples of the ammonium salt include tetrabutylammonium perchlorate, tetraethylammonium hexafluorophosphate, an imidazolium salt, and a pyridinium salt. Examples of the alkali metal salt include lithium perchlorate and potassium boron tetrafluoride. An example of the alkaline earth metal salt is bis(trifluoromethanesulfonyl)imide calcium(II). Examples of the transition metal salt include bis(trifluoromethanesulfonyl)imide zinc(II) and tris[4-tert-butyl-2-(1H-pyrazol-1-yl)pyridine] cobalt(III) tris(trifluoromethanesulfonyl)imide.

An example of the dopant is a fluorinated aromatic boron compound. An example of the fluorinated aromatic boron compound is tris(pentafluorophenyl)borane.

The solvent in the hole transport layer 8 may have high ionic conductivity. The solvent may be an aqueous solvent or an organic solvent. To make the solute more stable, the solvent in the hole transport layer 8 may be an organic solvent. Examples of the organic solvent include a heterocyclic compound solvent such as tert-butylpyridine, pyridine, and n-methylpyrrolidone.

The solvent may be an ionic liquid. The ionic liquid may be used alone or in combination with another solvent. The ionic liquid is preferable because of its low volatility and high flame resistance.

Examples of the ionic liquid include imidazolium-based ionic liquids, pyridine-based ionic liquids, alicyclic amine-based ionic liquids, aliphatic amine-based ionic liquids, and azonium amine-based ionic liquids, such as 1-ethyl-3-methylimidazolium tetracyanoborate.

The hole transport layer 8 may comprise, as an additive, at least one selected from the group consisting of tert-butylpyridine, bis(trifluoromethanesulfonyl)imide calcium(II), bis(trifluoromethanesulfonyl)imide zinc(II), tris[4-tert -butyl-2-(1H-pyrazol-1-yl)pyridine] cobalt(III) tris(trifluoromethanesulfonyl)imide, and tris(pentafluorophenyl)borane. This improves the hole transport properties of the hole transport layer 8. This can improve the photoelectric conversion efficiency of the photoelectric conversion element.

### (Second Electrode 9)

The second electrode 9 is conductive.

When the photoelectric conversion element does not include the hole transport layer 8, the second electrode 9 has blocking properties against electrons from the photoelectric conversion layer 7. In this case, the second electrode 9 is not in ohmic contact with the photoelectric conversion layer 7. The blocking properties against electrons from the photoelectric conversion layer 7 are properties that only allow passage of holes generated at the photoelectric conversion layer 7 and does not allow passage of electrons. The Fermi energy of a material having such properties may be lower than the energy of the photoelectric conversion layer 7 at the lower end of the valence band. The Fermi energy of a material having such properties may be lower than the Fermi energy of the photoelectric conversion layer 7. Specific examples of the material include platinum, gold, and a carbon material such as graphene.

When the photoelectric conversion element includes the hole transport layer 8, the second electrode 9 may have no blocking properties against holes from the photoelectric conversion layer 7. In this case, the second electrode 9 may be formed of a material that can form an ohmic contact with the photoelectric conversion layer 7. This allows the second electrode 9 to have light-transmitting properties.

Of the first electrode 5 and the second electrode 9, only at least one electrode that is located on a light-receiving side needs to have light-transmitting properties. Thus, one of the first electrode 5 and the second electrode 9 may have no light-transmitting properties. In other words, one of the first electrode 5 and the second electrode 9 does not need to contain a light-transmitting material and does not need to have a pattern having openings through which light passes.

### (Porous Layer 10)

The porous layer 10 is formed on the electron transport layer 6 by, for example, coating. If the photoelectric conversion element does not include the electron transport layer 6, the porous layer 10 is formed on the first electrode 5.

The pore structure given by the porous layer 10 serves as the foundation of the photoelectric conversion layer 7. The porous layer 10 does not inhibit light absorption of the photoelectric conversion layer 7 and electron transport from the photoelectric conversion layer 7 to the electron transport layer 6.

The porous layer 10 contains a porous material.

The porous material is formed, for example, of a series of insulating or semiconducting particles. Examples of the insulating particle include an aluminum oxide particle and a silicon oxide particle. An example of the semiconductor particle is an inorganic semiconductor particle. Examples of the inorganic semiconductor include metal oxide, perovskite oxide of a metal element, a sulfide of a metal element, and a metal chalcogenide. Examples of the metal oxide include oxides of Cd, Zn, In, Pb, Mo, W, Sb, Bi, Cu, Hg, Ti, Ag, Mn, Fe, V, Sn, Zr, Sr, Ga, Si, and Cr. An example of the metal oxide is TiO₂. Examples of the perovskite oxide of a metal element include SrTiO₃ and CaTiO₃. Examples of the sulfide of a metal element include CdS, ZnS, In₂S₃, PbS, Mo₂S, WS₂, Sb₂S₃, Bi₂S₃, ZnCdS₂, and Cu₂S. Examples of the metal chalcogenide include CsSe, In₂Se₃, WSe₂, HgS, PbSe, and CdTe.

The thickness of the porous layer 10 may be greater than or equal to 0.01 µm and less than or equal to 10 µm, or greater than or equal to 0.05 µm and less than or equal to 1 µm.

For the surface roughness of the porous layer 10, the surface roughness coefficient given by the effective area/the projected area may be greater than or equal to 10 or greater than or equal to 100. The projected area is the area of shadow created behind an object that is illuminated by light directly from the front. The effective area is the actual surface area of the object. The effective area can be calculated from the volume, which is determined from the projected area and the thickness of the object, and the specific surface area and the bulk density of the material constituting the object. The specific surface area is measured, for example, by nitrogen adsorption.

The voids in the porous layer 10 extend continuously through the porous layer 10 from one main surface to the other main surface. In other words, the voids in the porous layer 10 extend continuously from the main surface of the porous layer 10 in contact with the photoelectric conversion layer 7 to the main surface of the porous layer 10 in contact with the electron transport layer 6. This enables the material of the photoelectric conversion layer 7 to fill the voids in the porous layer 10 to the electron transport layer 6. Thus, the presence of the porous layer 10 does not prevent transport of electrons, because the photoelectric conversion layer 7 is in direct contact with the electron transport layer 6.

The presence of the porous layer 10 can make the formation of the photoelectric conversion layer 7 easy. Since the porous layer 10 is present, the material of the photoelectric conversion layer 7 enters the voids of the porous layer 10, allowing the porous layer 10 to function as a foothold for the photoelectric conversion layer 7. This reduces the possibility that the material of the photoelectric conversion layer 7 will be repelled by or agglomerated on the surface of the porous layer 10. Thus, the photoelectric conversion layer 7 can be readily formed as a uniform film. The photoelectric conversion layer 7 can be formed by the above coating, printing, or vapor deposition.

Light scattering caused by the porous layer 10 is also expected to elongate the optical path length of light passing through the photoelectric conversion layer 7. The increase in the optical path length will increase the number of electrons and holes generated in the photoelectric conversion layer 7.

### (Intermediate Layer 11)

The intermediate layer 11 includes a self-assembled monolayer having fullerene (C₆₀), a C₆₀ derivative, or C₆₀ (also referred to as "C60SAM"). The intermediate layer 11 efficiently collects electrons, reducing the resistance loss in transporting electrons to the electron transport layer 6.

Examples of the C₆₀ derivative include [6,6]-Phenyl C₆₁butyricacid methyl ester and [6,6]-Phenyl-C₆₁butyric acid butyl ester. Examples of the C60SAM include 4-(1',5'-Dihydro-1'-methyl-2'H-[5,6]fullereno-C₆₀-Ih-[1,9-c]pyrrol-2'-yl)benzoic acid, (1,2-methanofullerene C₆₀)-61-carboxylic acid, and C₆₀ Pyrrolidine tris-acid.

The intermediate layer 11 is formed, for example, by solution coating, immersing, printing, or vapor deposition.

### EXAMPLES

Hereafter, the present disclosure will be described in more detail with reference to examples and comparative examples.

In Examples and Comparative Examples, perovskite solar cells were produced, and the solar cells were evaluated in terms of the initial characteristics, the characteristics after the light resistance test, and the characteristics after the heat resistance test.

Components of the photoelectric conversion elements of the solar cells of Examples 1 to 3 and Comparative Examples 1 to 4 are as follows:
Substrate: a glass substrate (thickness: 0.7 mm);
First electrode: a transparent electrode (indium-tin composite oxide layer) (thickness: 200 nm);
Electron transport layer: titanium dioxide (TiO₂) (thickness: 10 nm);
Porous layer: a mesoporous titanium dioxide (TiO₂);
Intermediate layer: 4-(1',5'-Dihydro-1'-methyl-2'H-[5,6]fullereno-C₆₀-Ih-[1,9-c]pyrrol-2'-yl)benzoic acid (i.e., C60SAM) (manufactured by Sigma-Aldrich Co. LLC);
Photoelectric conversion layer: a layer containing HC(NH₂)₂PbI₃ as a main component (thickness: 500 nm);
Hole transport layer: a layer containing n-butylammonium bromide (manufactured by greatcellSolar Limited) and a layer containing PTAA as a main component (and tris(pentafluorophenyl)borane (TPFPB) (manufactured by Tokyo Chemical Industry Co., Ltd.) as an additive (thickness: 50 nm)); and
Second electrode: Au (thickness: 200 nm).

### <Production of Photoelectric Conversion Element>

### (Example 1)

First, a glass substrate having a thickness of 0.7 mm was provided. The substrate serves as the support of the solar cell of the present disclosure.

An indium-tin composite oxide layer was formed on the substrate by sputtering. In this way, the first electrode was formed.

Next, a titanium oxide layer was formed on the first electrode by sputtering. In this way, the electron transport layer was formed.

The electron transport layer was coated with 30NR-D (manufactured by Great Cell Solar Limited) by spin coating and then heat-treated at 500°C for 30 minutes to form a titanium oxide layer having a mesoporous structure. In this way, a porous layer was formed.

Next, the substrate having the porous layer and the layers formed prior to the porous layer was immersed in the C60SAM solution for 30 minutes and then taken out. Here, the C60SAM solution was obtained by adding C60SAM into a mixture containing tetrahydrofuran (manufactured by FUJIFILM Wako Pure Chemical Corporation) and ethanol (manufactured by FUJIFILM Wako Pure Chemical Corporation) in a 1:1 volume ratio so that its concentration becomes 1 × 10⁻⁵ mol/L. The substrate that was taken out was rinsed thoroughly with an ethanol solution and then annealed on a hot plate at 100°C for 30 minutes. After annealing, the substrate was allowed to cool naturally to room temperature, and a C60SAM-modified substrate was produced. In this way, the intermediate layer was formed.

Next, a raw material solution of a photoelectric conversion material was applied by spin coating to form a photoelectric conversion layer containing a perovskite compound. The raw material solution contains 0.92 mol/L of lead(II) iodide (manufactured by Tokyo Chemical Industry Co., Ltd.), 0.17 mol/L of lead(II) bromide (manufactured by Tokyo Chemical Industry Co., Ltd.), 0.83 mol/L of formamidinium iodide (manufactured by GreatCell Solar Limited), 0.17 mol/L of methylammonium bromide (manufactured by GreatCell Solar Limited), 0.05 mol/L of cesium iodide (manufactured by Iwatani Corporation), and 0.05 mol/L of rubidium iodide (manufactured by Iwatani Corporation). The solvent of the solution was a mixture of dimethyl sulfoxide (Acros) and N,N-dimethylformamide (Acros). The mixing ratio (DMSO:DMF) of dimethyl sulfoxide (DMSO) and N,N-dimethylformamide (DMF) in this raw solution was 1:4 by volume.

Next, a solution containing 6.49 × 10⁻³ mol/L of n-butylammonium bromide was applied on the photoelectric conversion layer by spin coating. The solvent was 2-propanol. Furthermore, a raw material solution of a hole transport material was applied by spin coating to form the hole transport layer. The raw material solution contains 10 g/L of PTAA and TPFPB, and the solvent is toluene (manufactured by Acros).

Next, an Au film was deposited on the hole transport layer by vacuum evaporation to form the second electrode 9. As above, the photoelectric conversion element was produced on the glass substrate, which is the support.

Next, sealing of the photoelectric conversion element was performed in a glove box in which the oxygen concentration was adjusted to 100 ppm. Here, the moisture concentration in the glove box was less than or equal to 0.1 ppm in terms of volume fraction. The photoelectric conversion element was sealed with a UV-curing resin, a cover glass, and the glass substrate. In other words, the photoelectric conversion element including the first electrode, the electron transport layer, the porous layer, the photoelectric conversion layer, the hole transport layer, and the second electrode was sealed with the UV-cured resin, the cover glass, and the glass substrate. As above, the solar cell according to Example 1 was produced. In the solar cell according to Example 1, the oxygen concentration in the sealed space is 100 ppm.

### (Example 2)

In Example 2, sealing of the photoelectric conversion element was performed in a glove box in which the oxygen concentration was adjusted to 1000 ppm. The solar cell according to Example 2 was produced in the same way as in Example 1 except for this.

### (Example 3)

In Example 3, sealing of the photoelectric conversion element was performed in a glove box in which the oxygen concentration was adjusted to 3000 ppm. The solar cell according to Example 3 was produced in the same way as in Example 1 except for this.

### (Example 4)

In Example 4, sealing of the photoelectric conversion element was performed in a glove box in which the oxygen concentration was adjusted to 10 ppm. The solar cell according to Example 4 was produced in the same way as in Example 1 except for the above.

### (Comparative Example 1)

In Comparative Example 1, sealing of the photoelectric conversion element was performed in a glove box in which the oxygen concentration was adjusted to 1 ppm. The solar cell according to Comparative Example 1 was produced in the same way as in Example 1 except for this.

### (Comparative Example 2)

In Comparative Example 2, sealing of the photoelectric conversion element was performed in a glove box in which the oxygen concentration was adjusted to 10000 ppm. The solar cell according to Comparative Example 2 was produced in the same way as in Example 1 except for this.

### (Comparative Example 3)

In Comparative Example 3, sealing of the photoelectric conversion element was performed in a glove box in which the oxygen concentration was adjusted to 100000 ppm. The solar cell according to Comparative Example 3 was produced in the same way as in Example 1 except for this.

### <Measurement of Photoelectric Conversion Efficiency>

The photoelectric conversion efficiency of solar cells according to Examples 1 to 4 and Comparative Examples 1 to 3 were measured.

The photoelectric conversion efficiency of the solar cells was measured using an electrochemical analyzer (ALS440B, manufactured by BAS) and a xenon light source (BPS X300BA, manufactured by Bunkoukeiki Co., Ltd.) for the initial state, after the light resistance test, and after the heat resistance test. Before the measurement, the light intensity was calibrated to 1 Sun (100 mW/cm²) by using a silicon photodiode. The voltage sweep rate was 100 mV/s. No preconditioning, such as light irradiation and prolonged forward bias application, was performed prior to the start of the measurement. To fix the effective area and reduce the influence of scattered light, the solar cell was masked with a black mask having an aperture of 0.1 cm² and irradiated with light from the masked glass substrate side. Photoelectric conversion efficiency was measured at room temperature and under dry air (<2% RH). Table 1 shows the open circuit voltage (Voc), the short circuit current density (Jsc), the fill factor (FF), and the photoelectric conversion efficiency (Eff) measured as above.

**[Table 1]**

| | OXYGEN CONCENTRATION (ppm) | V_{oc} (mV) | Jsc (mA/cm²) | FF | Eff (%) |
|---|---|---|---|---|---|
| Ex. 1 | 100 | 1088 | 22.05 | 0.776 | 18.63 |
| Ex. 2 | 1000 | 1088 | 21.83 | 0.772 | 18.33 |
| Ex. 3 | 3000 | 1090 | 21.77 | 0.770 | 18.27 |
| Ex. 4 | 10 | 1087 | 21.60 | 0.783 | 18.37 |
| Com. Ex. 1 | 1 | 1086 | 21.58 | 0.777 | 18.22 |
| Com. Ex. 2 | 10000 | 1030 | 21.45 | 0.725 | 16.01 |
| Com. Ex. 3 | 100000 | 1007 | 20.86 | 0.683 | 14.34 |

### <Light Resistance Test>

Light resistance tests were conducted on solar cells according to Examples 1 to 4 and Comparative Examples 1 to 3. In the light resistance test, the voltage and the current of the solar cells were kept near the optimal operating point, and the solar cells were exposed to light equivalent to 1 Sun from the substrate side for 71 hours with the temperature of the substrate being kept at 50°C. After the light resistance test, the photoelectric conversion efficiency of the solar cells was measured using the method described above. Table 2 shows the measurement results.

**[Table 2]**

| | OXYGEN CONCENTRATION (ppm) | V_{oc} (mV) | Jsc (mA/cm²) | FF | Eff (%) |
|---|---|---|---|---|---|
| Ex. 1 | 100 | 1059 | 21.26 | 0.721 | 16.23 |
| Ex. 2 | 1000 | 1055 | 21.48 | 0.733 | 16.61 |
| Ex. 3 | 3000 | 1034 | 20.63 | 0.701 | 14.96 |
| Ex. 4 | 10 | 1033 | 20.99 | 0.703 | 15.23 |
| Com. Ex. 1 | 1 | 1011 | 20.30 | 0.682 | 14.00 |
| Com. Ex. 2 | 10000 | 828 | 20.69 | 0.651 | 11.15 |
| Com. Ex. 3 | 100000 | 685 | 16.49 | 0.295 | 3.33 |

### <Heat Resistance Test>

A heat resistance test was conducted on the solar cells according to Examples 1 to 4 and Comparative Examples 1 to 3. The solar cells were kept in a thermostatic chamber at 85°C for 331 hours. After the heat resistance test, the photoelectric conversion efficiency of the solar cells was measured using the method described above. Table 3 shows the measurement results.

**[Table 3]**

| | OXYGEN CONCENTRATION (ppm) | V_{oc} (mV) | Jsc (mA/cm²) | FF | Eff (%) |
|---|---|---|---|---|---|
| Ex. 1 | 100 | 1030 | 21.77 | 0.751 | 16.84 |
| Ex. 2 | 1000 | 1061 | 21.17 | 0.712 | 16.00 |
| Ex. 3 | 3000 | 1052 | 21.09 | 0.706 | 15.67 |
| Ex. 4 | 10 | 1050 | 18.25 | 0.701 | 13.44 |
| Com. Ex. 1 | 1 | 1034 | 21.25 | 0.675 | 14.82 |
| Com. Ex. 2 | 10000 | 999 | 20.45 | 0.702 | 14.35 |
| Com. Ex. 3 | 100000 | 971 | 21.19 | 0.697 | 14.33 |

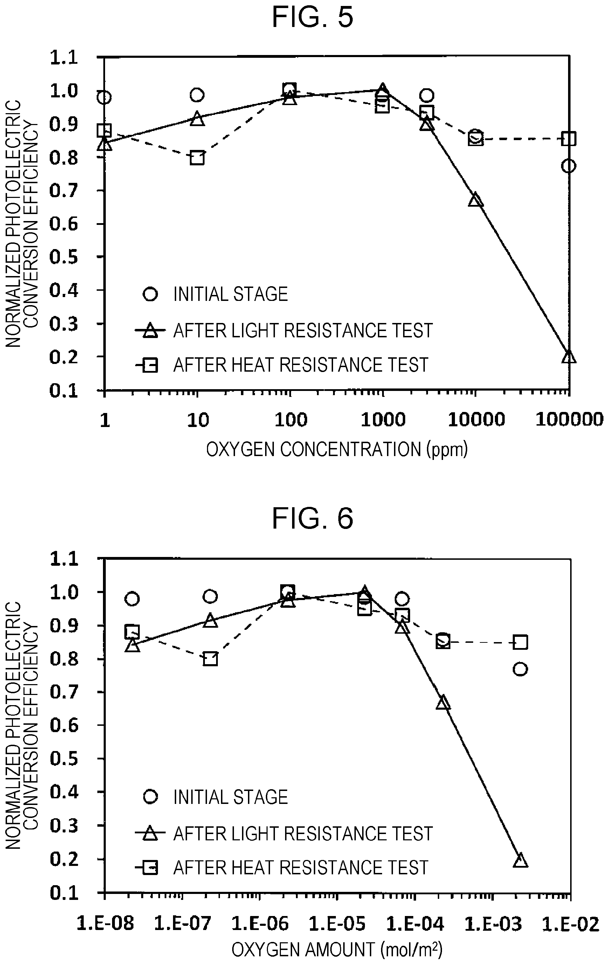

Fig. 5 is a graph showing the oxygen concentration dependence of the normalized photoelectric conversion efficiency of the solar cells of Examples 1 to 4 and Comparative Examples 1 to 3. Fig. 6 is a graph showing the oxygen amount dependence of the normalized photoelectric conversion efficiency of the solar cells according to Examples 1 to 4 and Comparative Examples 1 to 3. The normalized photoelectric conversion efficiency in Figs. 5 and 6 is normalized for the initial state, the state after light resistance test, and the state after heat resistance test in which the highest photoelectric conversion efficiency among Examples 1 to 4 and Comparative Examples 1 to 3 is set to 0. In Fig. 6, the oxygen concentrations in the sealed space indicated by the horizontal axis of Fig. 5 are converted to the values obtained by dividing the amount of oxygen by the surface area of the surface of the photoelectric conversion element facing the sealed space. The ideal gas law was used for the conversion. For the solar cells of Examples 1 to 4 and Comparative Examples 1 to 3, the volume of the sealed space was about 1.4 × 10⁻⁷ m³, and the surface area of the surface of the photoelectric conversion element facing the sealed space was 2.6 × 10⁻⁴ m².

### <Oxygen Concentration Effect on Initial Solar Cell Characteristics>

As shown in Table 1 and Fig. 5, there is no significant difference in the initial photoelectric conversion efficiency when the oxygen concentrations in the sealed space were less than or equal to 3000 ppm. The initial photoelectric conversion efficiency was stable without light irradiation and heating. However, when the oxygen concentrations were greater than or equal to 10000 ppm, the photoelectric conversion efficiency was lower. As the oxygen concentration increases, the drop rate of the photoelectric conversion efficiency increases. This may result from oxidation of the perovskite compound by excess oxygen.

### <Effect of Oxygen Concentration on Solar Cell Characteristics after Light Resistance Test>

As shown in Table 2 and Fig. 5, the photoelectric conversion efficiency after the light resistance test was high when the oxygen concentration in the sealed space is in the range of greater than or equal to 10 ppm and less than or equal to 3000 ppm. In contrast, the photoelectric conversion efficiency decreased in the low oxygen concentration region having the oxygen concentration of 1 ppm and in the high oxygen concentration region having the oxygen concentration of greater than or equal to 10000 ppm. The decrease in light resistance was particularly noticeable in Comparative Examples 2 and 3. When the oxygen concentration is greater than or equal to 10000 ppm, the degradation phenomenon induced by the excess oxygen may generate a large amount of reaction products with oxygen (metal oxides or metal hydroxides) or decomposition products of perovskite (metal iodides) on the surface and/or grain boundaries of the perovskite compound. This seems to have inhibited the movement of carriers and caused the decrease. In contrast, when the amount of oxygen is small, the products contribute to the passivation of defects in the perovskite compound, but when the oxygen concentration is less than or equal to 1 ppm, defect passivation under light may be insufficient, and carrier recombination through the defect level seems to have degraded the solar cell characteristics.

### <Effect of Oxygen Concentration on Solar Cell Characteristics after Heat Resistance Test>

As shown in Table 3 and Fig. 5, the photoelectric conversion efficiency after the heat resistance test was also high when the oxygen concentration in the sealed space was greater than or equal to 100 ppm and less than or equal to 3000 ppm. In contrast, the photoelectric conversion efficiency was lower than 15% in the low oxygen concentration region having an oxygen concentration of 10 ppm and in the high oxygen concentration region having an oxygen concentration of greater than or equal to 10000 ppm. The optimal oxygen concentration ranges exist after the light resistance test and the heat resistance test for the same reason. However, unlike the light resistance test, the lower limit of the optimal oxygen concentration range is high for the heat resistance test. This may be caused by differences in types and densities of defects caused in the perovskite compound under light and under heat. An increase in the energy of light applied in the light resistance test and an increase in the heating temperature in the heat resistance test may generate new defects depending on the activation energy for the generation of various defects. However, the conditions for the light resistance test and the heat resistance test in this example were set for actual outdoor operation. Thus, the optimal oxygen concentration range found by Examples for improving the durability of solar cells will remain the same.

From the above results, the durability of solar cells can be improved if the oxygen concentration in the sealed space is greater than or equal to 10 ppm and less than or equal to 3000 ppm. When the oxygen concentration in the sealed space is in the range of greater than or equal to 100 ppm and less than or equal to 3000 ppm, both the photostability and the thermal stability can be achieved.

### Industrial Applicability

This disclosure can significantly improve the durability of solar cells and has remarkably high industrial applicability.

### Reference Signs List

1, 100, 200, 300 photoelectric conversion element
2 support
3 sealing member
4 substrate
5 first electrode
6 electron transport layer
7 photoelectric conversion layer
8 hole transport layer
9 second electrode
10 porous layer
11 intermediate layer
1000 solar cell

## Claims

1. A solar cell comprising:
a support;
a photoelectric conversion element; and
a sealing member, wherein
the photoelectric conversion element is in a sealed space defined by the support and the sealing member,
the photoelectric conversion element comprises, in this order, a first electrode, a photoelectric conversion layer, and a second electrode, and
an oxygen concentration in the sealed space is greater than or equal to 10 ppm and less than or equal to 3000 ppm in terms of volume fraction.

2. A solar cell comprising:
a support;
a photoelectric conversion element; and
a sealing member, wherein
the photoelectric conversion element is in a sealed space defined by the support and the sealing member,
the photoelectric conversion element comprises, in this order, a first electrode, a photoelectric conversion layer, and a second electrode, and
a value obtained by dividing an oxygen amount in the sealed space by a surface area of a surface of the photoelectric conversion element that faces the sealed space is greater than or equal to 2.3 × 10⁻⁷ mol/m² and less than or equal to 7.0 × 10⁻⁵ mol/m².

3. The solar cell according to claim 1, wherein the oxygen concentration in the sealed space is greater than or equal to 100 ppm and less than or equal to 3000 ppm in terms of volume fraction.

4. The solar cell according to any one of claims 1 to 3, wherein a partial pressure of oxygen in the sealed space is greater than or equal to 1 × 10⁻⁵ atm and less than or equal to 3 × 10⁻³ atm.

5. The solar cell according to any one of claims 1 to 4, wherein the photoelectric conversion layer comprises a perovskite compound.

6. The solar cell according to claim 5, wherein the perovskite compound comprises lead.

7. The solar cell according to any one of claims 1 to 6, wherein the photoelectric conversion element further comprises a hole transport layer located between the photoelectric conversion layer and the second electrode, and
the hole transport layer comprises an organic semiconductor.

8. The solar cell according to claim 7, wherein the organic semiconductor comprises at least one selected from the group consisting of 2,2',7,7'-tetrakis-(N,N-di-p-methoxyphenylamine)9,9'-spirobifluorene and poly[bis(4-phenyl)(2,4,6-trimethylphenyl)amine].

9. The solar cell according to claim 7 or 8, wherein the hole transport layer further comprises an additive.

10. The solar cell according to claim 9, wherein the additive comprises at least one selected from the group consisting of tert-butylpyridine, bis(trifluoromethanesulfonyl)imide calcium(II), bis(trifluoromethanesulfonyl)imide zinc(II), tris[4-tert-butyl-2-(1H-pyrazol-1-yl)pyridine] cobalt(III) tris(trifluoromethanesulfonyl)imide, and tris(pentafluorophenyl)borane.

11. A method of producing a solar cell comprising sealing a photoelectric conversion element comprising, in this order, a first electrode, a photoelectric conversion layer, and a second electrode in an atmosphere having an oxygen concentration of greater than or equal to 10 ppm and less than or equal to 3000 ppm in terms of volume fraction.
